# EUROPEAN PATENT APPLICATION

(11) **EP 4 002 816 A1**
(43) Date of publication of application: **25.05.2022**
(21) Application number: 21155246.8
(22) Date of filing: 04.02.2021
(51) Int. Cl.: H04M 1/18

(54) **LUMINOUS PROTECTIVE CASE FOR AN ELECTRONIC DEVICE**

(30) Priority: 12.11.2020 CN 202022616982 U
(71) Applicant: Shenzhen Loksend Co.,Ltd, 518111 Shenzhen Guangdong (CN)
(72) Inventor: Zhu, Huisheng, Shenzhen, Guangdong 518111 (CN); Deng, Lingfeng, Shenzhen, Guangdong 518111 (CN)
(74) Representative: Ipey

(57) **Abstract**

A luminous protective case for an electronic device includes a casing that matches dimensions of the electronic device, an electronic circuit board provided along an inner side of a grooved frame of the casing, a magnetic adapter provided on the electronic circuit board and insertable into a preset interface of the electronic device, a plurality of light-emitting sources distributed in and along the grooved frame of the casing, and a main control circuit that controls the light-emitting sources. A magnetic end of the magnetic adapter is exposed from the casing. The luminous protective case for an electronic device can obtain electricity from the electronic device, charge the electronic device, and display a dazzling lighting effect along a side frame of the protective case. This can greatly enhance a user's experience.

## Description

### TECHNICAL FIELD

The present application relates to the field of electronic device accessories, in particular a luminous protective case for an electronic device.

### BACKGROUND TECHNOLOGY

As smart mobile devices are changing people's way of life, the role of their protective cases is no longer limited to the simple protection of the body of the device, but towards the direction of the variety of function, trendy and personalized style. How to create a novel and diversified protective case around the existing capabilities of mobile devices is a question that research and development designers in this field have been thinking about.

### SUMMARY

The present disclosure provides a luminous protective case for an electronic device, which can obtain electricity from the electronic device, charge the electronic device, and display a dazzling lighting effect along a side frame of the protective case. This can greatly enhance a user's experience.

A luminous protective case for an electronic device includes a casing that matches the dimensions of the electronic device, an electronic circuit board provided along an inner side of a grooved frame of the casing, a magnetic adapter provided on the electronic circuit board and insertable into a preset interface of the electronic device, a plurality of light-emitting sources distributed in and along the grooved frame of the casing, and a main control circuit that controls the plurality of light-emitting sources. A magnetic end of the magnetic adapter is exposed from the casing.

Optionally, each light-emitting source is an electroluminescent (EL) light source or a light-emitting diode (LED) light.

Optionally, the main control circuit is electrically connected with a wireless coil.

Optionally, the main control circuit is electrically connected with a rechargeable battery.

Optionally, the electronic circuit board includes a first printed circuit board carrying the magnetic adapter and a second printed circuit board carrying the plurality of light-emitting sources. The first printed circuit board and the second printed circuit board are electrically connected, and are both provided in and along the grooved frame of the casing. The second printed circuit board is a flexible printed circuit (FPC) board, and the second printed circuit board is divided into two strips and are electrically connected with the first printed circuit board respectively.

Optionally, a hollow frame body decoration piece is embedded in the casing for securing the first printed circuit board and the second printed circuit board, and notches are preset on the frame body decoration piece for accommodating the plurality of light-emitting sources.

Optionally, the casing includes a hollow side frame and a first cover plate. The magnetic adapter and the hollow side frame and the first cover plate are formed by two-shot injection molding.

Optionally, a second cover plate is provided in the casing and disposed on the frame body decoration piece.

Optionally, the main control circuit includes a light-emitting source control module, a power-taking module, and a charging module.

Optionally, the main control circuit further includes a sound detection module.

The present disclosure provides a luminous protective case for an electronic device. An electronic circuit board, carrying a magnetic adapter and light-emitting sources, is provided along the inner side edges of the casing. A magnetic end of the magnetic adapter is used for connecting to a magnetic charging head for the charging of the electronic device through a main control circuit. Another end of the magnetic adapter is used for inserting into a preset interface of the electronic device in order to obtain power from the electronic device. The obtained current can supply electricity to the light-emitting sources through the main control circuit. Through the improvement of the structure of the casing, the electronic circuit board is placed in a side frame position of the casing, so that after the light-emitting sources are supplied with electricity, a dazzling lighting effect will be produced around the entire casing of the protective case. This can greatly enhance a user's experience.

### BRIEF DESCRIPTION OF THE DRAWINGS

FIG. 1 is a schematic diagram of the structure of an embodiment of the luminous protective case of the present disclosure;
FIG. 2 is an exploded view of the structure of an embodiment of the luminous protective case of the present disclosure;
FIG. 3 is a schematic diagram of an embodiment of a circuit implementation of the light-emitting source control module of the present disclosure;
FIG. 4 is a schematic diagram of an embodiment of a circuit implementation of the power-taking module of the present disclosure; and
FIG. 5 is a schematic diagram of an embodiment of a circuit implementation of the sound detection module of the present disclosure.

Reference numbers in the drawings of the specification are as follows:
1-casing; 11-hollow side frame; 12-first cover plate; 2-magnetic adapter; 21-magnetic end; 3-electronic circuit board; 31-first printed circuit board; 32-second printed circuit board; 4-light-emitting source; 5-frame body decoration piece; 51-notch; 6-second cover plate.

### DETAILED DESCRIPTION OF THE EMBODFIMENTS

In order to make the technical problem to be solved by the present disclosure, the technical scheme, and the beneficial effect to be more clearly understood, the present disclosure is further elaborated together with the drawings and embodiments. It should be understood that the specific embodiments described here are used only to explain the present disclosure and are not intended to limit the present disclosure.

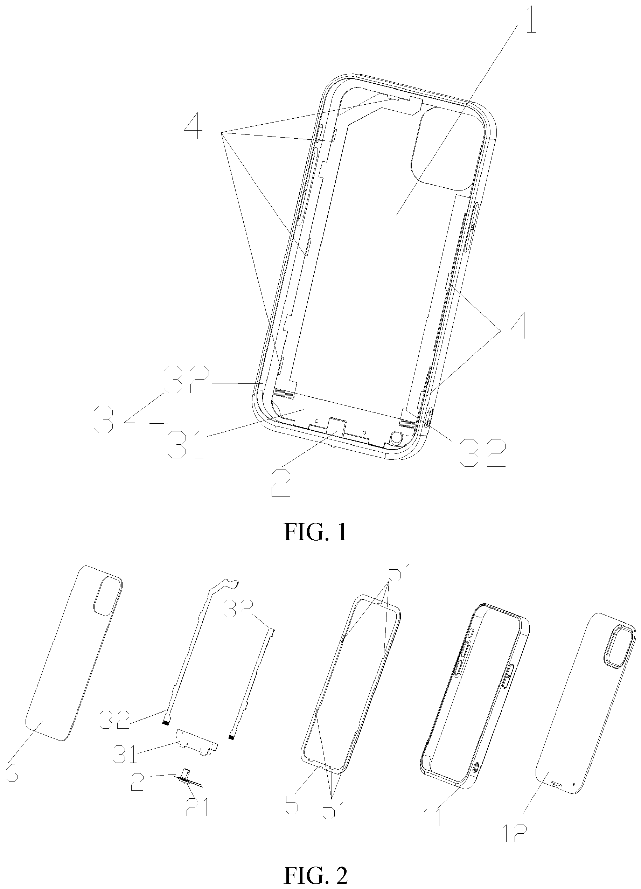

A luminous protective case for an electronic device, as shown in FIGS. 1-5, includes a casing 1 that matches the dimensions of the electronic device, an electronic circuit board 3 provided along an inner side of a grooved frame of the casing, a magnetic adapter 2 provided on the electronic circuit board and insertable into a preset interface of the electronic device, a plurality of light-emitting sources 4 distributed in and along the grooved frame of the casing, and a main control circuit that controls the light-emitting sources. A magnetic end 21 of the magnetic adapter is exposed from the casing.

Among them, the electronic device may include, but is not limited to, a smart terminal such as a smartphone, tablet, etc. The magnetic end of the magnetic adapter can be used for the charging of the electronic device, and the other end can be used to insert into a preset interface of the electronic device, such as USB, lightning interface, etc.

The light-emitting sources are distributed along a periphery of the casing and can produce a side lighting effect. Specifically, the light-emitting source can be a light-emitting diode (LED) light or an electroluminescent (EL) light source.

The electronic circuit board may adopt a narrow printed circuit board (PCB) for space saving and setting along the side frame of the casing.

Further, a wireless coil and a rechargeable battery may be respectively connected with the main control circuit, so that the protective case can be used to wirelessly charge an electronic product or charge as a back clip rechargeable battery, thus meeting more requirements of a user.

Further, in an embodiment, the electronic circuit board may be divided into a first printed circuit board 31 and a second printed circuit board 32 for easy installation, wherein the first printed circuit board is provided with the main control circuit and the magnetic adapter, and the second printed circuit board is provided with the light-emitting sources. Preferably, the second printed circuit board adopts two strips of flexible printed circuit (FPC) board respectfully distributed along an inner periphery of the casing. A flexible printed circuit board is lighter in weight and lower in cost.

Further, in an embodiment, a hollow frame body decoration piece is embedded in the casing for securing the first printed circuit board and the second printed circuit board. The frame body decoration piece is an overall rectangular hollow structure, and is preset with notches 51 for accommodating the light-emitting sources. The first printed circuit board and the second printed circuit board can be snap-fitted with the frame body decoration piece, and can be secured on the inner side of the casing together with the frame body decoration piece. At the same time, the notches on the frame body decoration piece can easily accommodate the light-emitting sources on the second printed circuit board.

Further, in an embodiment, the casing can be divided into a hollow side frame 11 and a first cover plate 12. The magnetic adapter, the hollow side frame and the first cover plate can be formed by two-shot injection molding. That is, the frame body as an independent piece, the first cover plate and the magnetic adapter are formed into one whole piece by two-shot injection molding. This can facilitate manufacturing and assembling. The two-shot injection molding is a kind of plastic molding process, and is also called over-injection molding or encapsulation.

Further, in an embodiment, a second cover plate 6 is provided in the casing and disposed on the frame body decoration piece. That is, the second cover plate is used to enclose the electronic circuit board on the first cover plate, and prevents it from contacting with the electronic device.

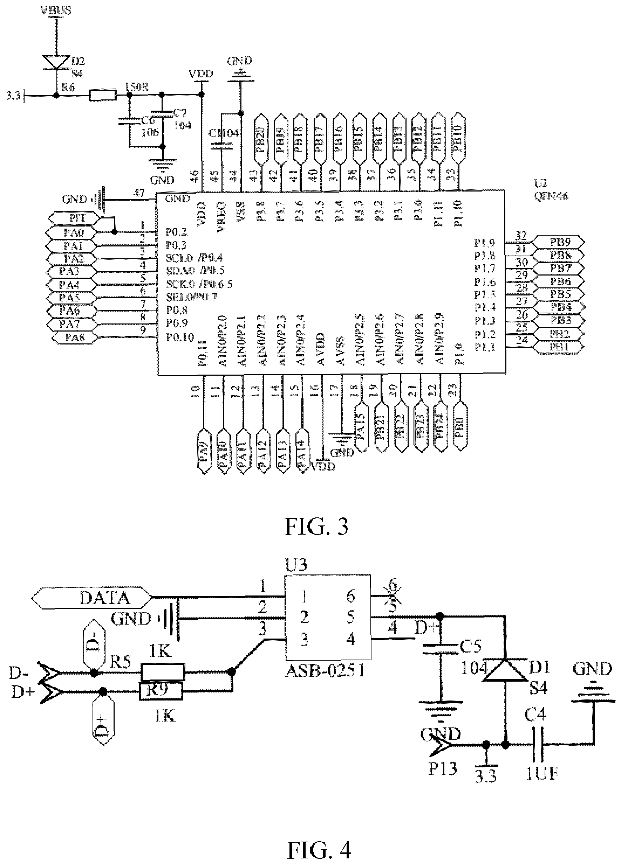

Further, in an embodiment, the main control circuit includes a light-emitting source control module, a power-taking module, and a charging module, wherein the light-emitting source control module is used for driving the light-emitting sources to work and form various lighting effects. A schematic diagram of its circuit implementation is shown in FIG. 3. The power-taking module is used for taking power from the electronic device. A schematic diagram of its circuit implementation is shown in FIG. 4. The charging module is used for charging of the electronic device. It needs to be mentioned that the symbols of the parts shown in the diagrams are standard symbols for the electronic parts, and they are not described here in detail.

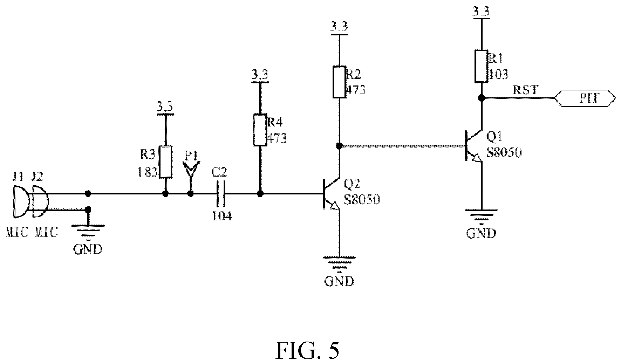

Further, in an embodiment, the main control circuit may further include a sound detection module. This module is used for picking up sound signals outside the electronic device and controlling the light-emitting sources according to the sound signals, such as flickering, turning off the lights, etc. A schematic diagram of its circuit implementation is shown in FIG. 5.

The above is an elaboration of the luminous protective case for an electronic device of the present disclosure, which is used for helping to understand the present disclosure. However, the implementation mode of the present disclosure is not limited by the above-mentioned embodiments. Any change, modification, substitution, combination and simplification made under the principle of the present disclosure shall be equivalent replacement and shall be included within the scope of protection of the present disclosure.

## Claims

1. A luminous protective case for an electronic device, comprising a casing that matches dimensions of the electronic device, an electronic circuit board provided along an inner side of a grooved frame of the casing, a magnetic adapter provided on the electronic circuit board and insertable into a preset interface of the electronic device, a plurality of light-emitting sources distributed in and along the grooved frame of the casing, and a main control circuit that controls the plurality of light-emitting sources; a magnetic end of the magnetic adapter being exposed from the casing.

2. The luminous protective case for an electronic device as claimed in claim 1, wherein each light-emitting source is an electroluminescent (EL) light source or a light-emitting diode (LED) light.

3. The luminous protective case for an electronic device as claimed in claim 1, wherein the main control circuit is electrically connected with a wireless coil.

4. The luminous protective case for an electronic device as claimed in claim 1, wherein the main control circuit is electrically connected with a rechargeable battery.

5. The luminous protective case for an electronic device as claimed in claim 1, wherein the electronic circuit board comprises a first printed circuit board carrying the magnetic adapter and a second printed circuit board carrying the plurality of light-emitting sources; the first printed circuit board and the second printed circuit board are electrically connected, and are both provided in and along the grooved frame of the casing; the second printed circuit board is a flexible printed circuit (FPC) board, the second printed circuit board is divided into two strips, which are electrically connected respectively with the first printed circuit board.

6. The luminous protective case for an electronic device as claimed in claim 5, wherein a hollow frame body decoration piece is embedded in the casing for securing the first printed circuit board and the second printed circuit board, and notches are preset on the frame body decoration piece for accommodating the plurality of light-emitting sources.

7. The luminous protective case for an electronic device as claimed in claim 6, wherein the casing comprises a hollow side frame and a first cover plate, the magnetic adapter and the hollow side frame and the first cover plate are formed by two-shot injection molding.

8. The luminous protective case for an electronic device as claimed in claim 7, wherein a second cover plate is provided in the casing and disposed on the frame body decoration piece.

9. The luminous protective case for an electronic device as claimed in claim 1, wherein the main control circuit comprises a light-emitting source control module, a power-taking module, and a charging module.

10. The luminous protective case for an electronic device as claimed in claim 9, wherein the main control circuit further comprises a sound detection module.
